# EUROPEAN PATENT APPLICATION

(11) **EP 2 617 787 A1**
(43) Date of publication of application: **24.07.2013**
(21) Application number: 13151408.5
(22) Date of filing: 16.01.2013
(51) Int. Cl.: C09J 7/02, C09J 133/08, C09J 133/10, H01L 21/00

(54) **Polymer for pressure sensitive adhesive, pressure sensitive adhesive composition and heat-peelable pressure sensitive adhesive sheet**

(30) Priority: 17.01.2012 JP 2012007495
(71) Applicant: NITTO DENKO CORPORATION, Ibaraki-shi, Osaka 567-8680 (JP)
(72) Inventor: Arimitsu, Yukio, Ibaraki-shi, Osaka 567-8680 (JP); Shimokawa, Daisuke, Ibaraki-shi, Osaka 567-8680 (JP)
(74) Representative: Grünecker, Kinkeldey, Stockmair & Schwanhäusser

(57) **Abstract**

A pressure sensitive adhesive having tackiness sufficient for fixing an article even when heated and having adhesive strength that may be lowered when heated to a higher temperature is provided so as to provide a pressure sensitive adhesive polymer that may be used for definitely fixing a member to be processed onto a pedestal or the like while performing desired processing or the like in a processing or assembling process and for smoothly removing the member from the pressure sensitive adhesive after the processing. The pressure sensitive adhesive polymer comprises a copolymer of a (meth)acrylic monomer represented by a general formula, CH₂=C(R1)COOR2 (wherein R1 is a hydrogen group or a methyl group and R2 is a hydrogen group or an alkyl group having of 1 to 20 carbon atoms) and a comonomer having a double bond copolymerizable with the (meth)acrylic monomer, in which the comonomer has a ring structure having two or more carbon atoms and one or more double bonds and containing one or more atoms other than carbon, and the polymer is obtained by copolymerizing 1 to 20 parts by weight of the monomer having a ring structure with 100 parts by weight of the (meth)acrylic monomer.

## Description

### BACKGROUND OF THE INVENTION

### Field of the Invention

The present invention relates to a polymer for a pressure sensitive adhesive (hereinafter referred to as a pressure sensitive adhesive polymer) and a heat-peelable pressure sensitive adhesive sheet to be used for fixing a component or a material for the component on a pedestal or the like in performing a processing and/or assembling process for the component particularly accompanied by heating.

### Description of the Related Art

Recent electronic components require compactness and precision of themselves, and for example, ceramic capacitors have been developed to have remarkably high capacity through downsizing typified in 0603 and 0402 sizes and through multilayered structures having layers in number much larger than several hundreds.
Particularly in the field of lamination of ceramic sheets obtained before baking (namely, green sheets) for ceramic capacitors or the like, there are increasing demands for processing accuracy for attaining the compactness and the precision.
A ceramic capacitor is manufactured, for example, through procedures of a step (1) of electrode printing on green sheets, a step (2) of lamination, a step (3) of high-pressure press, a step (4) of cutting and a step (5) of baking, successively performed in this order except that the steps (2) and (3) are alternately repeated.

The required processing accuracies are, for example, accuracy in electrode printing in the step (1), accuracy in electrode position in the step (2), accuracy in electrode shift caused by the high-pressure press in the step (3), and cutting accuracy in the step (4). If any one of these accuracies is poor in the manufacture, a resultant product has a failure, and hence the productivity is lowered.
In the cutting step (4) out of the aforementioned steps, a heat-peelable pressure sensitive adhesive sheet is used for improving the cutting accuracy. Thus, a ceramic capacitor may be firmly fixed in cutting, but the adhesive strength is lost by heating after the cutting step, and hence the cut ceramic capacitor may be easily peeled off from the sheet. In a cutting process particularly by force-cutting, however, the green sheet is softened by heating so as to be easily cut.
At this point, in a conventional heat-peelable sheet, adhesive strength attained under a high temperature atmosphere is liable to be largely lowered as compared with adhesive strength attained in a normal state. Owing to recent downsizing, an adhesion area per chip is so small that the conventional heat-peelable sheet may not show sufficient holding power during the cutting performed at a high temperature.

Therefore, in employing a method using a conventional tape as described in Japanese Patent Laid-Open Nos. 2008-239684 and 2006-241387, the tape has characteristics that it has adhesive strength at an ordinary temperature for firmly adhering (fixing) a target component through the steps of lamination and high-pressure press up to the cutting step but the tackiness is lowered after the cutting step. Specifically, the tackiness is lowered by heating when the tape includes a pressure sensitive adhesive layer to be foamed by heating, the tackiness is lowered by UV irradiation when the tape has tackiness lowered through the UV irradiation, or means for peeling off the tape with physical force is employed when the tape is a weakly adhesive tape.
Among methods using such tapes, a method using a tape designated as "Revalpha" is the most widely employed because this tape has satisfactory tackiness and may be peeled off without applying stress to a component after cutting.
In the case where a pressure sensitive adhesive layer to be foamed by heating is used, however, adhesive strength attained under a high temperature atmosphere may not be sufficient for attaining holding power necessary in processing for downsized components of these days in some cases. In such cases, a chip may be peeled off during the processing, resulting in lowering the yield.

### SUMMARY OF THE INVENTION

An object of the present invention is to provide a pressure sensitive adhesive having tackiness sufficient for fixing an article even under a heating atmosphere and having adhesive strength that may be lowered when heated to a higher temperature, so as to provide a pressure sensitive adhesive polymer that may be used for definitely fixing a member to be processed onto a pedestal or the like while performing desired processing or the like in a processing or assembling process, and for smoothly removing the member from the pressure sensitive adhesive after the processing.

In order to achieve the object, the present invention provides the following:
1. A heat-peelable adhesive comprising a pressure sensitive adhesive polymer comprising a copolymer of a (meth)acrylic monomer represented by a general formula, CH₂=C(R1)COOR2 (wherein R1 is a hydrogen group or a methyl group and R2 is a hydrogen group or an alkyl group having 1 to 20 carbon atoms) and a comonomer having a double bond copolymerizable with the (meth)acrylic monomer, wherein the comonomer is a monomer that has a ring structure having two or more carbon atoms and one or more double bonds and containing one or more atoms other than carbon, and the pressure sensitive adhesive polymer is obtained by copolymerizing 1 to 20 parts by weight of the monomer having a ring structure with 100 parts by weight of the (meth)acrylic monomer.
2. The heat-peelable adhesive according to 1, wherein the ring structure is a five- to seven-membered ring comprising carbon and nitrogen.
3. The heat-peelable adhesive according to 1 or 2, wherein the ring structure is a maleimide ring.
4. The heat-peelable adhesive according to any one of 1 to 3, wherein the monomer having a ring structure is at least one or more of N-phenylmaleimide, N-cyclohexylmaleimide and N-(4-aminophenyl)maleimide.
5. The heat-peelable adhesive according to any one of 1 to 4, containing thermally expansive microspheres.
6. A heat-peelable pressure sensitive adhesive sheet comprising a layer of a heat-peelable adhesive composition according to 5 formed on one or both faces of a substrate.
7. The heat-peelable pressure sensitive adhesive sheet according to 6, wherein the heat-peelable pressure sensitive adhesive sheet has adhesive strength against a PET film in a 60°C atmosphere of 1 to 10 N/20 mm.
8. The heat-peelable pressure sensitive adhesive sheet according to 7, wherein the heat-peelable pressure sensitive adhesive sheet has a shear modulus of 0.01 to 1 MPa in a 60°C atmosphere.
9. The heat-peelable pressure sensitive adhesive sheet according to 7 or 8, wherein the heat-peelable pressure sensitive adhesive sheet has a glass transition temperature of -20 to 25°C.
10. A method for manufacturing a semiconductor product or an electronic component by using a heat-peelable pressure sensitive adhesive sheet according to any one of 6 to 9.

According to the present invention, adhesive strength of a pressure sensitive adhesive may be prevented from lowering under a high temperature atmosphere, a range of appropriate adhesive strength may be kept, and therefore, a member or a component may be accurately and definitely fixed on a pedestal during a processing/assembling process for which heating is required or caused as a consequence.
Besides, when the process is completed and there is no need to fix the member or the component on the pedestal or the like with the pressure sensitive adhesive any more, the adhesive strength is lowered by foaming a pressure sensitive adhesive layer by heating to a higher temperature, so that sufficient heat-peelability may be attained.

### DESCRIPTION OF THE DRAWING

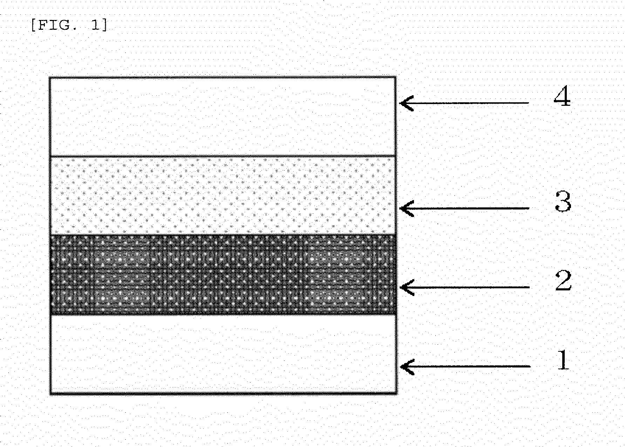

FIG. 1 is a cross-sectional view of a heat-peelable pressure sensitive adhesive sheet.

### DETAILED DESCRIPTION OF THE PREFERRED EMBODIMENTS

The present invention provides a heat-peelable adhesive comprising a pressure sensitive adhesive polymer comprising a copolymer of a (meth)acrylic monomer represented by a general formula, CH₂=C(R1)COOR2 (wherein R1 is a hydrogen group or a methyl group and R2 is a hydrogen group or an alkyl group having of 1 to 20 carbon atoms) and a comonomer having a double bond copolymerizable with the (meth)acrylic monomer, in which the comonomer is a monomer that has a ring structure having two or more carbon atoms and one or more double bonds and containing one or more atoms other than carbon, and the pressure sensitive adhesive polymer is obtained by copolymerizing 1 to 20 parts by weight of the monomer having a ring structure with 100 parts by weight of the (meth)acrylic monomer. It has been found that when this heat-peelable adhesive is used, the adhesive strength may be effectively prevented from lowering and may be effectively kept in an appropriate range as required in high temperature processing or processing in which a high temperature is partly caused as a consequence, and in addition, sufficient heat-peelability may be secured.

A general heat-peelable adhesive contains an acrylic copolymer as a base, and additives of such as a tackifier such as a resin, a plasticizer, a pigment, a filler, a conductive agent and an antistatic agent, thermally expansive microspheres (a foaming agent), a multifunctional epoxy compound, and a crosslinking agent such as an isocyanate compound.
According to the present invention, by introducing a monomer having a ring structure having an element with strong polarity such as a nitrogen element into a (meth)acrylic copolymer, adhesive strength onto an adherend of a metal, a resin or a ceramic (a green sheet) under a high temperature atmosphere may be improved.
In general, however, high adhesive strength affects peelability in many cases, and when acrylic acid or methacrylic acid, that is, a typical polar monomer, is used, although the adhesive strength attained under a high temperature atmosphere may be increased, the polarity is too strong to degrade heat-peelability, that is, a significant requisite for a heat-peelable sheet, and hence, sufficient characteristics may not be attained in some cases.

The pressure sensitive adhesive of the present invention may further contain thermally expansive microspheres and various known additives that may be added to a pressure sensitive adhesive if necessary, and thus, a heat-peelable adhesive may be obtained.
A heat-peelable pressure sensitive sheet may be obtained by forming a layer comprising the thus obtained heat-peelable adhesive on one face of a substrate directly or with one or more layers sandwiched therebetween.

### ((Meth)acrylic Monomer)

A layer of the heat-peelable adhesive of the present invention uses a polymer comprising a copolymer of a (meth)acrylic monomer represented by a general formula, CH₂=C(R1)COOR2 (wherein R1 is a hydrogen group or a methyl group and R2 is a hydrogen group or an alkyl group having 1 to 20 carbon atoms) and a comonomer having a double bond copolymerizable with the (meth)acrylic monomer, in which the comonomer is a monomer that has a ring structure having two or more carbon atoms and one or more double bonds and containing one or more atoms other than carbon, and the polymer is obtained by copolymerizing 1 to 20 parts by weight, preferably 2 to 15 parts by weight and more preferably 3 to 12 parts by weight of the monomer having a ring structure with 100 parts by weight of the (meth)acrylic monomer.
Specific examples of monomers constituting general acrylic polymers are acrylic alkyl esters of acrylic acid or methacrylic acid having an alkyl group generally having 20 or less carbon atoms, such as a methyl group, an ethyl group, a propyl group, a butyl group, a 2-ethylhexyl group, an isooctyl group, an isinonyl group, an isodecyl group, a dodecyl group, a lauryl group, a tridecyl group, a pentadecyl group, a hexadecyl group, a heptadecyl group, an octadecyl group, a nonadecyl group or an eicosyl group; acrylic acid, methacrylic acid, itaconic acid, hydroxyethyl acrylate, hydroxyethyl methacrylate, hydroxypropyl acrylate, hydroxypropyl methacrylate, N-methylol acrylamide, acrylonitrile, methacrylonitrile, glycidyl acrylate, glycidyl methacrylate, vinyl acetate, styrene, isoprene, butadiene, isobutylene and vinyl ether.

### (Comonomer having Ring Structure)

Examples of the monomer having a ring structure and having an element other than carbon, for example, an element with strong polarity such as a nitrogen element, are maleimides, maleic anhydrides, thiophenes, pyrroles, anilines and furans, among which maleimides are preferably used in the present invention, and among the maleimides, N-cyclohexylmaleimide, N-phenylmaleimide, and N-(4-aminophenyl)maleimide are more preferable.
The present inventors have found the following: When a monomer having a ring structure containing an element with strong polarity such as a nitrogen element is copolymerized with a monomer having a vinyl group represented by a general formula, CH₂=C(R1)COOR2, the ring structure is present on a main chain of the resultant polymer, so as to suppress movement of the main chain and to attain a high glass transition temperature Tg even when included in a small amount. Therefore, tackiness attained at a high temperature may be improved.
Furthermore, it has been found that since this effect may be attained by using a small amount of monomer as a copolymerization component, monomers generally used for forming a pressure sensitive adhesive layer may be used as most of components of the polymer, and hence, tackiness attained at a high temperature may be improved without spoiling the tackiness at an ordinary temperature.
In addition, since elements having large polarity such as a nitrogen element, a sulfur element or an oxygen element are present in the polymer, the tackiness may be expected to be further improved.

### (Other Comonomers)

Copolymerizable monomer components copolymerizable with the monomer may be further additionally used for the copolymerization. Examples of such a copolymerizable monomer are carboxyl group-containing monomers such as acrylic acid, methacrylic acid, carboxyethyl acrylate, carboxypentyl acrylate, itaconic acid, maleic acid and crotonic acid; hydroxyl group-containing monomers such as 2-hydroxyethyl (meth)acrylate, 2-hydroxypropyl (meth)acrylate, 4-hydroxybutyl (meth)acrylate, 6-hydroxyhexyl (meth)acrylate, 8-hydroxyoctyl (meth)acrylate, 10-hydroxydecyl (meth)acrylate, 12-hydroxylauryl (meth)acrylate and (4-hydroxymethyl cyclohexyl)-methyl acrylate; anhydride monomers such as maleic anhydride and itaconic anhydride; sulfonic group-containing monomers such as 2-acrylamide-2-methylpropanesulfonic acid and sulfopropyl acrylate; phosphate group-containing monomers such as 2-hydroxyethylacryloylphosphate; amide monomers such as (meth)acrylamide and N-substituted (meth)acrylamide including N-methylolacrylamide; succinimide monomers such as N-(meth)acryloyloxymethylenesuccinimide, N-(meth)acryloyl-6-oxyhexamethylenesuccinimide and N-(meth)acryloyl-8-oxyoctamethylenesuccinimide; vinyl monomers such as vinyl acetate, N-vinyl pyrrolidone, N-vinyl carboxylic acid amides and styrene; cyanoacrylate monomers such as acrylonitrile and methacrylonitrile; acrylate monomers such as glycidyl (meth)acrylate, tetrahydrofurfuryl (meth)acrylate, polyethylene glycol (meth)acrylate, polypropylene glycol (meth)acrylate, fluorine (meth)acrylate, silicone (meth)acrylate and 2-methoxyethyl acrylate; alkyl (meth)acrylates having a different alkyl group from the alkyl (meth)acrylate used as a principal component, such as methyl (meth)acrylate and octadecyl (meth)acrylate; and alicyclic acrylates such as isobornyl (meth)acrylate.

### (Polymer Used in Heat-Peelable Adhesive)

For synthesizing the polymer of the present invention, the aforementioned monomer components may be copolymerized by any of known methods such as suspension polymerization, block polymerization and emulsion polymerization. In the copolymerization, any of known polymerization initiators, reaction solvents, chain transfer agents, emulsifiers and the like may be used if necessary.
As for the contents of the respective monomer components used in the polymer, based on 100 parts by weight of the (meth)acrylic monomer, 1 to 20 parts by weight, preferably 2 to 15 parts by weight and more preferably 3 to 12 parts by weight of the comonomer having a ring structure is used, and 0 to 20 parts by weight, preferably 3 to 15 parts by weight and more preferably 4 to 12 parts by weight of the other comonomers is used.
Particularly when the comonomer having a ring structure is included by 1 to 20 parts by weight, adhesive strength attained at 60°C may fall within an appropriate range, and excellent heat-peelability may be also attained.

### (Thermally Expansive Microspheres)

When thermally expansive microspheres are included in the heat-peelable adhesive obtained as above, a thermally expanding property may be provided, so that the thus obtained composition may be used for forming a thermally expansive layer used as described later.
The thermally expansive microspheres may be used by involving, in a shell forming substance, an appropriate substance that may be easily gasified to show a thermally expanding property, such as isobutane, propane or pentane, by coacervation, interfacial polymerization or the like. The thermally expansive microspheres to be used have a volume expansion ratio of 5 or more and preferably 10 or more.

As the shell forming substance used for producing the thermally expansive microspheres, for example, a vinylidene chloride-acrylonitrile copolymer, polyvinyl alcohol, polyvinyl butyral, polymethyl methacrylate, polyacrylonitrile, polyvinylidene chloride and polysulfone are generally used. In the present invention, the shell forming substance may be a hot melt substance or a substance broken through thermal expansion or the like.

The average particle size of the thermally expansive microspheres to be used may be appropriately determined, and is, but not limited to, generally 100 µm or less, preferably 80 µm or less and particularly preferably 1 to 50 µm. It is noted that commercially available microspheres (such as Matsumoto Microsphere F-50D, manufactured by Matsumoto Yushi-Seiyaku Co., Ltd.) may be used as the thermally expansive microspheres.
The content of the thermally expansive microspheres may be appropriately determined in accordance with a degree of expanding (foaming) the layer of the heat-peelable adhesive and a degree of lowering the adhesion strength. In general, the content is 10 to 100 parts by weight, preferably 15 to 80 parts by weight and more preferably 20 to 60 parts by weight based on 100 parts by weight of the pressure sensitive adhesive polymer. When the content is 10 to 50 parts by weight, the layer of the heat-peelable adhesive may be foamed when heated, so as to appropriately lower the adhesive strength.

### (Crosslinking Agent)

The crosslinking agent may be, for example, an isocyanate crosslinking agent, an epoxy crosslinking agent or the like.
Examples of the isocyanate crosslinking agent (a polyfunctional isocyanate compound) are lower aliphatic polyisocyanates such as 1,2-ethylene diisocyanate, 1,4-butylene diisocyanate and 1,6-hexamethylene diisocyanate; cycloaliphatic polyisocyanates such as cyclopentylene diisocyanate, cyclohexylene diisocyanate, isophorone diisocyanate, hydrogenated trilene diisocyanate and hydrogenated xylene diisocynate; and aromatic polyisocyanates such as 2,4-trilene diisocyanate, 2,6-trilene diisocyanate, 4,4'-diphenylmethane diisocyanate and xylylene diisocyanate. Among the aforementioned compounds, the aromatic polyisocyanates are preferably used. Commercially available crosslinking agents such as "Collonate L" (trade name of a trimethylol propane/trilene diisocyanate adduct manufactured by Nippon Polyurethane Industry Co., Ltd.), "Collonate HL" (trade name of a trimethylol propane/hexamethylene diisocyanate adduct manufactured by Nippon Polyurethane Industry Co., Ltd.) and "Takenate 110N" (trade name; manufactured by Mitsui Chemicals Co., Ltd.) may be used.

Examples of the epoxy crosslinking agent (a multifunctional epoxy compound) are N,N,N',N'-tetraglycidyl-m-xylenediamine, diglycidylaniline, 1,3-bis(N,N-diglycidylaminomethyl)cyclohexane, 1,6-hexanediol diglycidyl ether, neopentyl glycol diglycidyl ether, ethylene glycol diglycidyl ether, propylene glycol diglycidyl ether, polyethylene glycol diglycidyl ether, polypropylene glycol diglycidyl ether, sorbitol polyglycidyl ether, glycerol polyglycidyl ether, pentaerythritol polyglycidyl ether, polyglycerol polyglycidyl ether, sorbitan polyglycidyl ether, trimethyrol propane polyglycidyl ether, adipic acid diglycidyl ester, o-phthalic acid diglycidyl ester, triglycidyl-tris(2-hydroxyethyl)isocyanurate, resorcin diglycidyl ether, bisphenol-S-diglycidyl ether, and epoxy resins having two or more epoxy groups in a molecule. A commercially available crosslinking agent such as "Tetrad-C" (trade name; manufactured by Mitsubishi Gas Chemical Company, Inc.) may be used.
In addition, melamine crosslinking agents and epoxy crosslinking agents may be used.
The content of such a crosslinking agent is 0 to 5 parts by weight and preferably 0.5 to 3 parts by weight based on 100 parts by weight of the pressure sensitive adhesive polymer. The content may be determined in consideration of degrees of cohesion and adhesive strength of the pressure sensitive adhesive polymer to be obtained.

### (Tackifier)

A tackifier may be included, and any of known tackifiers may be used. Examples of such a tackifier are rosin resins, rosin esters, terpene resins (such as terpene-aromatic liquid resins and polyterpene resins), coumarone resins, indene resins, coumarone indene resins, petroleum resins (such as C5 petroleum resins and C5/C9 petroleum resins) and phenol resins.
The content of such a tackifier is 0 to 20 parts by weight and preferably 0 to 15 parts by weight based on 100 parts by weight of the polymer.

### (Other Additives)

The heat-peelable adhesive may further include a phthalic acid-based plasticizer, a fatty acid-based plasticizer, a filler and the like.
Examples of the phthalic acid-based plasticizer are phthalate esters such as dioctyl phthalate (DOP), dioctyl tin laurate (DOTL), dibutyl phthalate (DBP), dilauryl phthalate (DLP), butyl benzyl phthalate (BBP), diisodecyl phthalate (DIDP), diisononyl phthalate (DINP), dimethyl phthalate and diethyl phthalate.

Examples of the fatty acid-based plasticizer are adipate esters such as dioctyl adipate (DOA), diisononyl adipate (DINA), diisodecyl adipate, adipic acid propylene glycol polyester and adipic acid butylene glycol polyester.

Furthermore, examples of a usable plasticizer are higher alcohols (such as lauryl alcohol and stearyl alcohol), drying oils and animal and vegetable oils (such as paraffins (including paraffin oil), waxes, naphthenes, aromas, asphalts and linseed oil), petroleum oils, low-molecular weight polymers, and organic esters (such as phosphate, higher fatty acid ester and alkyl sulfonate).

These plasticizers may be used singly or as a combination of two or more. Among these plasticizers, the fatty acid-based plasticizers are preferably used, and adipate is more preferably used.
As the filler, known fillers such as talc and silica may be used.
In addition, the heat-peelable adhesive may include an antioxidant, a surface active agent, a pigment, a conductive agent and an antistatic agent.

The layer comprising the heat-peelable adhesive containing the thermally expansive microspheres obtained using the aforementioned ingredients has a adhesive strength, under a 60°C atmosphere, of 1 to 10 N/20 mm and preferably 1.5 to 8 N/20 mm. When the adhesive strength attained under the 60°C atmosphere is 1 to 10 N/20 mm, it may hold an adherend, no failure is caused during the processing process, and in addition, the adhesive strength attained in heat-peeling is not too high, so as to avoid a failure in which an adherend may not be peeled off even when the thermally expansive microspheres are foamed.

Furthermore, the layer of the heat-peelable adhesive has a storage shear modulus, under a 60°C atmosphere, of 0.01 to 1 MPa and preferably 0.05 to 0.7 MPa. When the storage shear modulus is in a range of 0.01 to 1 MPa, even if stress is applied to an adherend during the processing process, the pressure sensitive adhesive is not too soft and hence deformation of the layer of the heat-peelable adhesive may be prevented, and therefore, no accuracy failure is caused. Furthermore, the pressure sensitive adhesive is not too hard, and hence a sufficient adherence may be obtained and an adherend may be sufficiently held.
Moreover, the glass transition temperature Tg of the pressure sensitive adhesive is -20 to 25°C and preferably -15 to 20°C. When the glass transition temperature Tg is -20 to 25°C, the effect of using the monomer having a ring structure may be sufficiently attained, so as to show adhesive strength at a high temperature. Furthermore, an elastic modulus attained at room temperature is not too high, and hence, a sticking property is not degraded.

### (Heat-peelable Pressure Sensitive Adhesive Sheet)

FIG. 1 illustrates an example of a heat-peelable pressure sensitive adhesive sheet of the present invention. In this drawing, a reference numeral 1 denotes a substrate, a reference numeral 2 denotes a rubber-like organic elastic layer, a reference numeral 3 denotes a thermally expansive layer comprising a heat-peelable adhesive, and a reference numeral 4 denotes a smooth peelable film. In the example illustrated in FIG. 1, the thermally expansive layer containing the heat-peelable adhesive is provided on one face of the substrate.
Incidentally, the heat-peelable pressure sensitive adhesive sheet may be further provided, in addition to the thermally expansive layer formed above one face of the substrate with the rubber-like organic elastic layer sandwiched therebetween, with an ordinary pressure sensitive adhesive layer on the other face of the substrate, and needless to say, the thermally expansive layer may be provided on both the faces of the substrate.

The substrate works as a supporting base of an adhesive sheet and is generally a plastic film or sheet but may be an appropriate thin leaf body such as paper, cloth, nonwoven cloth, a metal foil, a plastic laminated body of such a material or a laminated body of plastics. The substrate generally has a thickness of, but not limited to, 5 to 250 µm.

The rubber-like organic elastic layer includes one that works to provide a large adhesion area owing to a surface thereof excellently following a surface shape of an adherend in adhering the pressure sensitive adhesive sheet onto the adherend; and one that works to help the thermally expansive layer to form a wavy structure through three-dimensional structural change by reducing restraint in foaming and/or expanding along a plane direction of the pressure sensitive adhesive sheet in thermally foaming and/or expanding the thermally expansive layer for peeling the adherend from the pressure sensitive adhesive sheet.
The rubber-like organic elastic layer may be made of natural rubber, a synthetic rubber or a synthetic resin with rubber elasticity having D-type Shore D hardness, based on ASTM D-2240, of 50 or less and preferably 40 or less.

Examples of the synthetic rubber or the synthetic resin are nitrile, diene or acrylic synthetic rubber, a polyolefin or polyester thermoplastic elastomer, an ethylene-vinyl acetate copolymer, and synthetic resins with rubber elasticity such as polyurethane, polybutadiene and plasticized polyvinyl chloride. It is noted that a substantially rigid polymer such as polyvinyl chloride may be used in the present invention as far as it is provided with rubber elasticity through combination with a formulation ingredient such as a plasticizer or a softener.
Furthermore, the rubber-like organic elastic layer may be made of a generally known rubber-based or resin-based pressure sensitive adhesive agent.

As such a pressure sensitive adhesive agent, an appropriate one of a rubber-based pressure sensitive adhesive agent, an acrylic-based pressure sensitive adhesive agent, a styrene-conjugated diene block copolymer-based pressure sensitive adhesive agent and the like may be used. Furthermore, a pressure sensitive adhesive agent including a hot-melt resin having a melting point of approximately 200°C or less for improving creep properties may be used. It is noted that the pressure sensitive adhesive agent may include appropriate additives such as a crosslinking agent, a tackifier, a plasticizer, a filler and an antioxidant.
More specific examples are rubber-based pressure sensitive adhesive agents including natural rubber or synthetic rubber as a base polymer; and acrylic-based pressure sensitive adhesive agents using an acrylic polymer as a base polymer including, as a principal component, acrylic alkyl esters of acrylic acid or methacrylic acid including an alkyl group generally having 20 or less carbon atoms, such as a methyl group, an ethyl group, a propyl group, a butyl group, a 2-ethylhexyl group, an isooctyl group, an isinonyl group, an isodecyl group, a dodecyl group, a lauryl group, a tridecyl group, a pentadecyl group, a hexadecyl group, a heptadecyl group, an octadecyl group, a nonadecyl group or an eicosyl group; acrylic acid, methacrylic acid, itaconic acid, hydroxyethyl acrylate, hydroxyethyl methacrylate, hydroxypropyl acrylate, hydroxypropyl methacrylate, N-methylol acrylamide, acrylonitrile, methacrylonitrile, glycidyl acrylate, glycidyl methacrylate, vinyl acetate, styrene, isoprene, butadiene, isobutylene and vinyl ether.

The thermally expansive layer containing the heat-peelable adhesive is obtained by allowing any of the aforementioned thermally expansive materials to be included in the above-described polymer, which comprises a copolymer of a (meth)acrylic monomer represented by a general formula, CH₂=C(R1)COOR2 (wherein R1 is a hydrogen group or a methyl group and R2 is a hydrogen group or an alkyl group having 1 to 20 carbon atoms) and a comonomer having a double bond copolymerizable with the (meth)acrylic monomer, in which the comonomer is a monomer that has a ring structure having two or more carbon atoms and one or more double bonds and containing one or more elements other than carbon, and the polymer is obtained by copolymerizing 1 to 20 parts by weight of the monomer having a ring structure with 100 parts by weight of the (meth)acrylic monomer.

Each of the thermally expansive layer and the rubber-like organic elastic layer has a thickness of 5 to 300 µm and preferably 20 to 150 µm. When both of them have a thickness of 5 to 300 µm, they are not too thin to lower the adhesion strength attained before heating because of surface flatness spoiled by irregularities caused by the thermally expansive microspheres, and a cohesive failure may be prevented from occurring after the foaming so as to prevent the pressure sensitive adhesive from remaining on an adherend.
The smooth peelable film is what is called a release liner, and it protects, before use of the heat-peelable pressure sensitive adhesive sheet of the present invention, the surface of the thermally expansive layer for preventing occurrence of flaws and adhesion of dusts thereon. In advance of use, the peelable film is peeled off so as to expose the surface of the thermally expansive layer. Thus, a semiconductor component or an electronic component to be protected may be prevented from being damaged or stained during the processing process.

Conditions for the heat treatment for allowing the pressure sensitive adhesive sheet to be easily peeled off from an adherend are determined in accordance with various conditions such as reduction of an adhesion area depending upon a surface state of an adherend, the kind of thermally expansive microspheres and the like, heat resistance of the substrate and the adherend, and a heating method and the like. In general, the heat treatment is conducted at 100 to 250°C for 1 to 90 seconds (in using a hot plate or the like) or 5 to 15 minutes (in using a hot air dryer or the like).

### (Manufacture of Semiconductor Products and Electronic Components)

The heat-peelable adhesive and the heat-peelable pressure sensitive adhesive sheet of the present invention may be utilized for manufacturing semiconductor products and electronic components that are produced through processing for, for example, cutting, polishing and dicing wafers and that are produced through a process intentionally or unintentionally accompanied by heating in processing ceramic capacitors or IC packages or the like obtained by forming patterns on green sheets by electrode printing or the like.
In manufacture of, for example, an IC package of a laminate type, in a process where local heating is caused by frictional heat or the like as in a punching process of forming through holes in a plurality of stacked green sheets, the green sheets are fixed on a pedestal by using the heat-peelable adhesive of the present invention.
Even when exposed to local heating caused in the punching process, the adhesive strength of the heat-peelable adhesive is not lowered so that the green sheets may be definitely fixed.

### EXAMPLES

### Measurement Method for Adhesive Strength (N/20 mm)

A prepared sheet sample was cut into a sample strip with a width of 20 mm and a length of 140 mm, and PET #25 (with a width of 30 mm) was used as an adherend. The sample and the adherend were adhered to each other in an ordinary state in accordance with JIS Z 0237, and the resultant was set in a tensile tester equipped with a thermostat precedently set to 60°C and was allowed to stand for 5 minutes. Thereafter, a load obtained in peeling the adherend at a peel angle of 180° and a peel rate of 300 mm/min was measured as a adhesive strength.

### Measurement Method for Storage Shear Modulus (MPa)

A loss shear modulus T along a shear direction was measured by using a viscoelasticity testing system, ARES manufactured by Rheometric Scientific, Inc. under the following conditions:
ω : 1 Hz
Plate Diameter: 7.9 φ
Strain: 0.30 (at 60°C)

### Measurement Method for Glass Transition Temperature Tg (°C)

A loss tangent (Tan δ) obtained in applying stress in the shear direction was measured by using the viscoelasticity testing system, ARES manufactured by Rheometric Scientific, Inc. under the following conditions, and a temperature at which the maximum value was shown was obtained as the glass transition temperature Tg:
ω : 1 Hz
Plate Diameter: 7.9 φ
Strain: 0.3% (at -30°C to 60°C)

### Measurement Method for Heat-peelability

A heat-peelable pressure sensitive adhesive sheet sample prepared by using a heat-peelable adhesive was cut into a sample strip with a width of 10 mm and a length of 40 mm, the strip was adhered, with a hand roller, onto an SUS 304BA stainless steel sheet having been ultrasonic cleaned, and the resultant was stored in a dryer set to a 40°C atmosphere for 1 day.
The sample strip was taken out of the dryer, cooled at room temperature, and subjected to a heat treatment (with a hot air dryer) at 130°C for 10 min, and thereafter, a peeling state of the sample of the heat-peelable pressure sensitive adhesive sheet was visually observed. The result was evaluated as ○ when it was peeled off and X when it failed to peel.

### Example 1

A coating liquid in which 100 parts by weight of a copolymer of ethyl acrylate/2-ethylhexyl acrylate/hydroxyethyl acrylate (55 parts by weight/45 parts by weight/5 parts by weight) and 1.5 parts by weight of an isocyanate crosslinking agent were homogeneously mixed and dissolved in toluene was applied onto a support substrate (of PET with a thickness of 100 µm) into a thickness of 35 µm attained after drying and then dried, so as to form a rubber-like organic elastic layer. Subsequently, a coating liquid in which 100 parts by weight of a copolymer of ethyl acrylate/2-ethylhexyl acrylate/hydroxyethyl acrylate/N-hexylmaleimide (55 parts by weight/45 parts by weight/5 parts by weight/5 parts by weight), 1.5 parts by weight of an isocyanate crosslinking agent and 30 parts by weight of thermally expansive microspheres foaming and expanding when heated to 120°C were homogeneously mixed and dissolved in toluene was applied onto a separator (a PET substrate with a thickness of 38 µm) into a thickness of 45 µm attained after drying and then dried, so as to form a thermally expansive layer. After drying, the thus obtained thermally expansive layer was adhered onto the rubber-like organic elastic layer formed on the support substrate, and thus, a heat-peelable pressure sensitive adhesive sheet of the present invention was obtained.

### Comparative Example 1

A heat-peelable pressure sensitive adhesive sheet was obtained in the same manner as in Example 1 except that ethyl acrylate/2-ethylhexyl acrylate/hydroxyethyl acrylate (55 parts by weight/45 parts by weight/5 parts by weight) was used in forming a thermally expansive layer.

### Example 2

A coating liquid in which 100 parts by weight of a copolymer of ethyl acrylate/2-ethylhexyl acrylate/hydroxyethyl acrylate (70 parts by weight/30 parts by weight/5 parts by weight) and 1 part by weight of an isocyanate crosslinking agent were homogeneously mixed and dissolved in toluene was applied onto a support substrate (of PET with a thickness of 100 µm) into a thickness of 15 µm attained after drying and then dried, so as to form a rubber-like organic elastic layer. Subsequently, a coating liquid in which 100 parts by weight of a copolymer of ethyl acrylate/2-ethylhexyl acrylate/hydroxyethyl acrylate/N-phenylmaleimide (70 parts by weight/30 parts by weight/5 parts by weight/2.5 parts by weight), 1 part by weight of an isocyanate crosslinking agent, 7 parts by weight of a rosin phenol resin and 30 parts by weight of thermally expansive microspheres foaming and expanding when heated to 120°C were homogeneously mixed and dissolved in toluene was applied onto a separator (a PET substrate with a thickness of 38 µm) into a thickness of 35 µm attained after drying and then dried, so as to form a thermally expansive layer. After drying, the thus obtained thermally expansive layer was adhered onto the rubber-like organic elastic layer formed on the support substrate, and thus, a heat-peelable pressure sensitive adhesive sheet of the present invention was obtained.

### Example 3

A coating liquid in which 100 parts by weight of a copolymer of ethyl acrylate/2-ethylhexyl acrylate/hydroxyethyl acrylate (70 parts by weight/30 parts by weight/5 parts by weight) and 1 part by weight of an isocyanate crosslinking agent were homogeneously mixed and dissolved in toluene was applied onto a support substrate (of PET with a thickness of 100 µm) into a thickness of 15 µm attained after drying and then dried, so as to form a rubber-like organic elastic layer. Subsequently, a coating liquid in which 100 parts by weight of a copolymer of ethyl acrylate/2-ethylhexyl acrylate/hydroxyethyl acrylate/N-phenylmaleimide (70 parts by weight/30 parts by weight/5 parts by weight/5 parts by weight), 1 part by weight of an isocyanate crosslinking agent, 7 parts by weight of a rosin phenol resin and 30 parts by weight of thermally expansive microspheres foaming and expanding when heated to 120°C were homogeneously mixed and dissolved in toluene was applied onto a separator (a PET substrate with a thickness of 38 µm) into a thickness of 35 µm attained after drying and then dried, so as to form a thermally expansive layer. After drying, the thus obtained thermally expansive layer was adhered onto the rubber-like organic elastic layer formed on the support substrate, and thus, a heat-peelable pressure sensitive adhesive sheet of the present invention was obtained.

### Example 4

A coating liquid in which 100 parts by weight of a copolymer of ethyl acrylate/2-ethylhexyl acrylate/hydroxyethyl acrylate (70 parts by weight/30 parts by weight/5 parts by weight) and 1 part by weight of an isocyanate crosslinking agent were homogeneously mixed and dissolved in toluene was applied onto a support substrate (of PET with a thickness of 100 µm) into a thickness of 15 µm attained after drying and then dried, so as to form a rubber-like organic elastic layer. Subsequently, a coating liquid in which 100 parts by weight of a copolymer of ethyl acrylate/2-ethylhexyl acrylate/hydroxyethyl acrylate/N-phenylmaleimide (70 parts by weight/30 parts by weight/5 parts by weight/10 parts by weight), 1 part by weight of an isocyanate crosslinking agent, 7 parts by weight of a rosin phenol resin and 30 parts by weight of thermally expansive microspheres foaming and expanding when heated to 120°C were homogeneously mixed and dissolved in toluene was applied onto a separator (a PET substrate with a thickness of 38 µm) into a thickness of 35 µm attained after drying and then dried, so as to form a thermally expansive layer. After drying, the thus obtained thermally expansive layer was adhered onto the rubber-like organic elastic layer formed on the support substrate, and thus, a heat-peelable pressure sensitive adhesive sheet of the present invention was obtained.

### Example 5

A coating liquid in which 100 parts by weight of a copolymer of ethyl acrylate/2-ethylhexyl acrylate/hydroxyethyl acrylate (70 parts by weight/30 parts by weight/5 parts by weight) and 1 part by weight of an isocyanate crosslinking agent were homogeneously mixed and dissolved in toluene was applied onto a support substrate (of PET with a thickness of 100 µm) into a thickness of 15 µm attained after drying and then dried, so as to form a rubber-like organic elastic layer. Subsequently, a coating liquid in which 100 parts by weight of a copolymer of ethyl acrylate/2-ethylhexyl acrylate/hydroxyethyl acrylate/N-phenylmaleimide (70 parts by weight/30 parts by weight/5 parts by weight/5 parts by weight), 1.5 parts by weight of an isocyanate crosslinking agent, 5 parts by weight of a rosin phenol resin and 40 parts by weight of thermally expansive microspheres foaming and expanding when heated to 120°C were homogeneously mixed and dissolved in toluene was applied onto a separator (a PET substrate with a thickness of 38 µm) into a thickness of 35 µm attained after drying and then dried, so as to form a thermally expansive layer. After drying, the thus obtained thermally expansive layer was adhered onto the rubber-like organic elastic layer formed on the support substrate, and thus, a heat-peelable pressure sensitive adhesive sheet of the present invention was obtained.

### Comparative Example 2

A heat-peelable pressure sensitive adhesive sheet was obtained in the same manner as in Example 2 except that ethyl acrylate/2-ethylhexyl acrylate/hydroxyethyl acrylate (70 parts by weight/30 parts by weight/5 parts by weight) was used in forming a thermally expansive layer.

### Comparative Example 3

A heat-peelable pressure sensitive adhesive sheet was obtained in the same manner as in Example 2 except that ethyl acrylate/2-ethylhexyl acrylate/acrylic acid (70 parts by weight/30 parts by weight/10 parts by weight) was used in forming a thermally expansive layer

### Example 6

A coating liquid in which 100 parts by weight of a copolymer of ethyl acrylate/2-ethylhexyl acrylate/hydroxyethyl acrylate (70 parts by weight/30 parts by weight/5 parts by weight) and 1.5 parts by weight of an isocyanate crosslinking agent were homogeneously mixed and dissolved in toluene was applied onto a support substrate (of PET with a thickness of 100 µm) into a thickness of 15 µm attained after drying and then dried, so as to form a rubber-like organic elastic layer. Subsequently, a coating liquid in which 100 parts by weight of a copolymer of ethyl acrylate/2-ethylhexyl acrylate/hydroxyethyl acrylate/N-phenylmaleimide (70 parts by weight/30 parts by weight/5 parts by weight/10 parts by weight), 1.5 parts by weight of an isocyanate crosslinking agent, 10 parts by weight of a terpene phenol resin and 30 parts by weight of thermally expansive microspheres foaming and expanding when heated to 120°C were homogeneously mixed and dissolved in toluene was applied onto a separator (a PET substrate with a thickness of 38 µm) into a thickness of 35 µm attained after drying and then dried, so as to form a thermally expansive layer. After drying, the thus obtained thermally expansive layer was adhered onto the rubber-like organic elastic layer formed on the support substrate, and thus, a heat-peelable pressure sensitive adhesive sheet of the present invention was obtained.

### Example 7

A coating liquid in which 100 parts by weight of a copolymer of ethyl acrylate/2-ethylhexyl acrylate/hydroxyethyl acrylate (70 parts by weight/30 parts by weight/5 parts by weight) and 1.5 parts by weight of an isocyanate crosslinking agent were homogeneously mixed and dissolved in toluene was applied onto a support substrate (of PET with a thickness of 100 µm) into a thickness of 15 µm attained after drying and then dried, so as to form a rubber-like organic elastic layer. Subsequently, a coating liquid in which 100 parts by weight of a copolymer of ethyl acrylate/2-ethylhexyl acrylate/hydroxyethyl acrylate/N-phenylmaleimide (70 parts by weight/30 parts by weight/5 parts by weight/10 parts by weight), 1.5 parts by weight of an isocyanate crosslinking agent, 10 parts by weight of a terpene phenol resin and 50 parts by weight of thermally expansive microspheres foaming and expanding when heated to 120°C were homogeneously mixed and dissolved in toluene was applied onto a separator (a PET substrate with a thickness of 38 µm) into a thickness of 35 µm attained after drying and then dried, so as to form a thermally expansive layer. After drying, the thus obtained thermally expansive layer was adhered onto the rubber-like organic elastic layer formed on the support substrate, and thus, a heat-peelable pressure sensitive adhesive sheet of the present invention was obtained.

### Comparative Example 4

A heat-peelable pressure sensitive adhesive sheet was obtained in the same manner as in Example 2 except that ethyl acrylate/2-ethylhexyl acrylate/hydroxyethyl acrylate (70 parts by weight/30 parts by weight/5 parts by weight) was used in forming a thermally expansive layer.
The physical properties and characteristics of the heat-peelable pressure sensitive adhesive sheets obtained in Examples 1 to 6 and Comparative Examples 1 to 4 are shown in Table 1.

**[Table 1]**

| | Adhesion at 60°C (N/20 mm) | Storage Shear Modulus at 60°C (MPa) | Tg (°C) | Heat-peelability |
|---|---|---|---|---|
| Example 1 | 1.8 | 0.34 | -9.3 | ○ |
| Example 2 | 2.9 | 0.18 | -2.2 | ○ |
| Example 3 | 4.8 | 0.19 | 4.0 | ○ |
| Example 4 | 6.4 | 0.23 | 13.8 | ○ |
| Example 5 | 3.8 | 0.25 | 3.7 | ○ |
| Example 6 | 2.6 | 0.28 | 19.2 | ○ |
| Example 7 | 1.9 | 0.30 | 19.4 | ○ |
| Comparative Example 1 | 0.4 | 0.30 | -21.2 | ○ |
| Comparative Example 2 | 0.8 | 0.17 | -8.5 | ○ |
| Comparative Example 3 | 12.8 | 0.14 | -2.0 | × |
| Comparative Example 4 | 0.4 | 0.26 | -3.5 | ○ |

It is understood that the heat-peelable pressure sensitive adhesive sheets of the present invention (Examples 1 to 7) are superior to those of Comparative Examples 1, 2 and 4 in the adhesive strength (N/20 mm) in a 60°C atmosphere and have a characteristic that they may be easily peeled off from an adherend by heating. It is also understood that the heat-peelability is degraded when the adhesive strength is too high as in Comparative Example 3.
Accordingly, in the case where a pressure sensitive adhesive composition containing the pressure sensitive adhesive polymer of the present invention is used in a step where heating at least to 60°C is conducted or where heat of at least 60°C is caused during processing, the adhesive strength is never lowered under such a heating atmosphere, and hence the pressure sensitive adhesive composition may sufficiently function as a pressure sensitive adhesive.
In addition, since thermally expansive microspheres are included, the peelability may be attained at a temperature of their expansion, and a component having been processed may be definitely removed from a pedestal or the like after the processing.

## Claims

1. A heat-peelable adhesive comprising a pressure sensitive adhesive polymer comprising a copolymer of a (meth)acrylic monomer represented by a general formula, CH₂=C(R1)COOR2 (wherein R1 is a hydrogen group or a methyl group and R2 is a hydrogen group or an alkyl group having 1 to 20 carbon atoms) and a comonomer having a double bond copolymerizable with the (meth)acrylic monomer, wherein the comonomer is a monomer that has a ring structure having two or more carbon atoms and one or more double bonds and containing one or more atoms other than carbon, and the pressure sensitive adhesive polymer is obtained by copolymerizing 1 to 20 parts by weight of the monomer having a ring structure with 100 parts by weight of the (meth)acrylic monomer.

2. The heat-peelable adhesive according to claim 1,
wherein the ring structure is a five- to seven-membered ring comprising carbon and nitrogen.

3. The heat-peelable adhesive according to claim 1 or 2, wherein the ring structure is a maleimide ring.

4. The heat-peelable adhesive according to any one of claims 1 to 3,
wherein the monomer having a ring structure is at least one or more of N-phenylmaleimide, N-cyclohexylmaleimide and N-(4-aminophenyl)maleimide.

5. The heat-peelable adhesive according to any one of claims 1 to 4, containing thermally expansive microspheres.

6. A heat-peelable pressure sensitive adhesive sheet comprising a layer comprising a heat-peelable adhesive according to claim 5 formed on one or both faces of a substrate.

7. The heat-peelable pressure sensitive adhesive sheet according to claim 6,
wherein the heat-peelable pressure sensitive adhesive sheet has adhesive strength against a PET film in a 60°C atmosphere of 1 to 10 N/20 mm.

8. The heat-peelable pressure sensitive adhesive sheet according to claim 7,
wherein the heat-peelable pressure sensitive adhesive sheet has a shear modulus of 0.01 to 1 MPa in a 60°C atmosphere.

9. The heat-peelable pressure sensitive adhesive sheet according to claim 7 or 8,
wherein the heat-peelable pressure sensitive adhesive sheet has a glass transition temperature of -20 to 25°C.

10. A method for manufacturing a semiconductor product or an electronic component by using a heat-peelable pressure sensitive adhesive sheet according to any one of claims 6 to 9.
